# EUROPEAN PATENT APPLICATION

(11) **EP 4 836 296 A1**
(43) Date of publication of application: **04.11.2026**
(21) Application number: 26168512.7
(22) Date of filing: 27.03.2026
(51) Int. Cl.: H03F 3/45

(54) **OFFSET CALIBRATION IN DIFFERENTIAL CIRCUITS**

(30) Priority: 29.04.2025 IN 202541041591
(71) Applicant: NXP B.V., 5656 AG Eindhoven (NL)
(72) Inventor: Singh, Prashant, 5656AG Eindhoven (NL); Kumar, Saurabh, 5656AG Eindhoven (NL)
(74) Representative: Schwarzweller, Thomas

(57) **Abstract**

A circuit (102a) includes a differential circuit (202) and a calibration circuit (204). The differential circuit (202) includes input control terminals to receive differential input signals, current supply terminals to receive calibration currents, and output control terminals to generate differential output signals based on the differential input signals and the calibration currents. The calibration circuit (204) is coupled to the differential circuit (202). The calibration circuit (204) includes calibration current sources to generate the calibration currents. Further, the calibration circuit (204) includes control inputs to receive control signals to control activation of the calibration current sources, and control outputs to provide the calibration currents at the current supply terminals, to calibrate an offset between the differential output signals.

## Description

### FIELD OF USE

The present disclosure relates generally to differential circuits and, more particularly, to offset calibration in differential circuits.

### BACKGROUND

Differential signal processing circuits are critical in providing noise immunity and signal integrity in high-speed communication systems. However, inherent offset errors arise in such circuits due to process variations, temperature fluctuations, and power supply instability, leading to degradation of an overall performance of the differential circuits. Conventional offset measurement and calibration techniques experience low residual common mode after offset calibration leading to linearity issues and direct current (DC) gain variation. Additionally, for multistage differential circuits, such offset amplifies with each stage further affecting performance of the system.

### BRIEF DESCRIPTION OF DRAWINGS

The following detailed description of the embodiments of the present disclosure will be better understood when read in conjunction with the appended drawings. The present disclosure is illustrated by way of example, and not limited by the accompanying figures, in which like references indicate similar elements.
FIG. 1 illustrates a schematic block diagram of a circuit including a multistage differential circuit in accordance with an embodiment of the present disclosure;
FIG. 2 illustrates a schematic circuit diagram of a first differential circuit of the multistage differential circuit of FIG. 1 in accordance with an embodiment of the present disclosure;
FIG. 3 illustrates a schematic circuit diagram of the first differential circuit of FIG. 1 in accordance with another embodiment of the present disclosure;
FIG. 4 illustrates a schematic circuit diagram of a control circuit of the circuit of FIG. 1 in accordance with an embodiment of the present disclosure; and
FIGS. 5A and 5B, collectively, represent a flowchart illustrating a method for offset calibration performed by the circuit of FIG. 1 in accordance with an embodiment of the present disclosure.

### DETAILED DESCRIPTION

The detailed description of the appended drawings is intended as a description of the embodiments of the present disclosure, and is not intended to represent the only form in which the present disclosure may be practiced. It is to be understood that the same or equivalent functions may be accomplished by different embodiments that are intended to be encompassed within the spirit and scope of the present disclosure.

Differential circuits are susceptible to offset errors that may arise due to process variations, power supply fluctuations, temperature changes, and long-term component drift. The offset errors introduce imbalances in differential output signals, thereby affecting signal accuracy and overall system performance. Conventional offset correction techniques employ continuous feedback loops coupled at output terminals of the differential circuits to dynamically calibrate the offset. However, such conventional techniques implement complex circuitry which introduce additional parasitic capacitance at outputs of the differential circuits resulting in degradation of 3 decibel (dB) bandwidth and the output signal parameters.

Other known static calibration techniques utilize predefined calibration currents provided at the output terminals of the differential circuits to compensate for offset errors. However, such techniques experience lower residual common mode after offset calibration leading to linearity issues (1 dB compression) and direct current (DC) gain variation. As circuit design scales and operational tolerances become increasingly stringent, maintaining consistent and precise offset calibration presents a significant challenge. In high-precision applications such as analog front-end circuits, high-speed communication interfaces, and sensor-based measurement systems, an offset deviation can adversely impact an operational accuracy of the system. Further, for multistage differential circuits, the offset amplifies with each differential stage thereby affecting an overall performance of the system.

Various embodiments of the present disclosure disclose a circuit comprising a differential circuit and a calibration circuit. The differential circuit may include input terminals to receive differential input signals, supply terminals (nodes) to receive calibration currents, and output terminals to generate differential output signals based on the differential input signals and the calibration currents. The calibration circuit may further receive a set of control signals to control steering of the calibration currents. Based on the steering of the calibration currents, the calibration circuit may provide the calibration currents at the supply terminals of the differential circuit to calibrate an offset between the differential output signals.

In contrast to conventional techniques, the present disclosure may selectively steer the calibration currents based on the set of control signals to provide the calibration currents at the supply terminals as compared to the output terminals of the differential circuit. The disclosed circuit may thus facilitate offset calibration in real-time thereby enhancing accuracy and reliability of differential circuits under varying operating conditions.

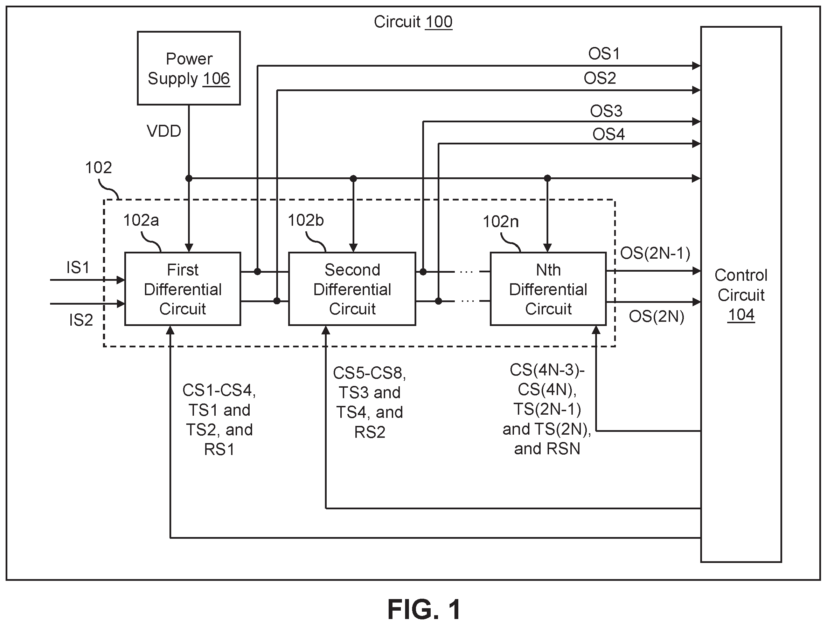

FIG. 1 illustrates a schematic block diagram of a circuit 100 including a multistage differential circuit in accordance with an embodiment of the present disclosure. The circuit 100 may include a multistage differential circuit 102 including first through Nth differential circuits 102a-102n, a control circuit 104, and a power supply 106. The circuit 100 may be implemented in communication applications such as Serializer/Deserializer (SerDes) interface or memory interfaces, for example, Peripheral Component Interconnect Express (PCIE) communication interface, Universal Serial Bus (USB) 3.1 interface, Double Data Rate (DDR) memory, and the like, but may be used in other types of circuits in other embodiments.

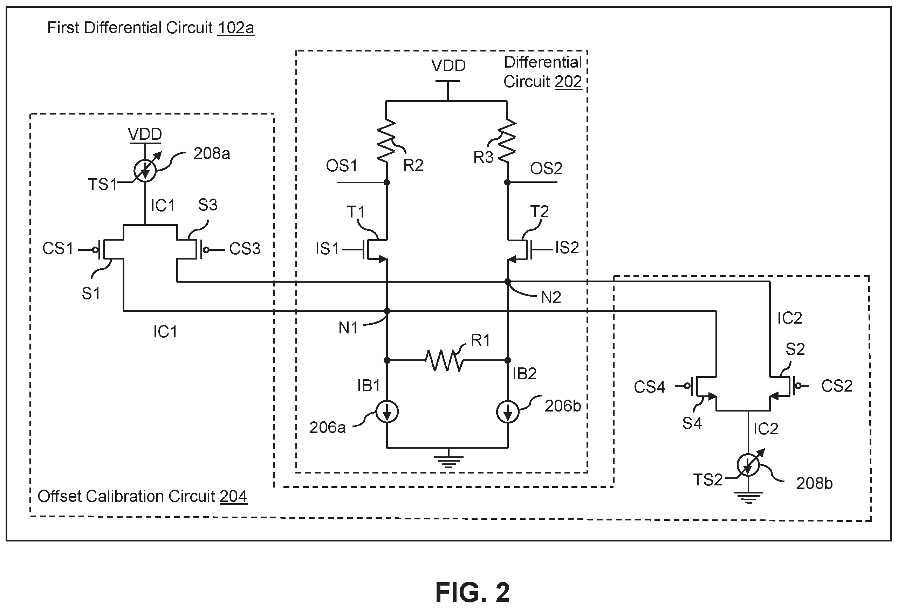

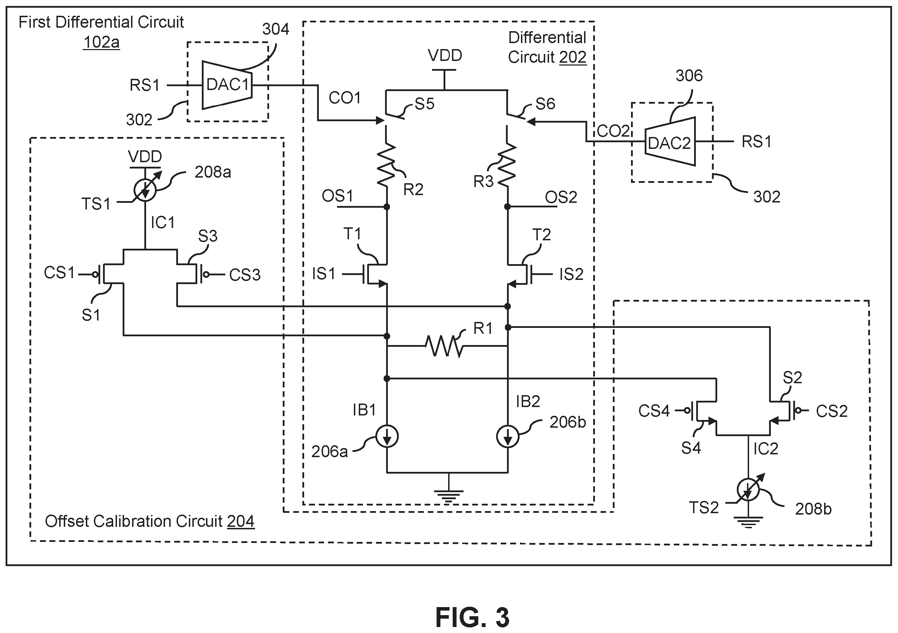

In one embodiment, each of the first through Nth differential circuits 102a-102n may correspond to an amplifier stage of a multistage amplifier circuit. Each amplifier stage may include a differential circuit and an offset calibration circuit (shown in FIGS. 2 and 3). The differential circuits may receive differential inputs and generate differential outputs. In some scenarios, the differential outputs may include an offset error. To calibrate the offset error, the control circuit 104 may control the offset calibration circuit to provide calibration currents to the differential circuit. In one embodiment, the calibration currents may be provided to the differential circuit at a source side of the differential circuit. The offset calibration has been explained in detail in FIGS. 2 and 3.

Each of the first through Nth differential circuits 102a-102n may be coupled to the control circuit 104 and the power supply 106. The first through Nth differential circuits 102a-102n may be coupled sequentially such that a subsequent differential circuit may receive differential outputs generated by a preceding differential circuit, as differential inputs. In one embodiment, the first differential circuit 102a may receive a supply voltage VDD, differential input signals, e.g., first and second input signals IS1 and IS2, a first set of control signals CS1-CS4, and a first set of tuning signals TS1-TS2. Based on the supply voltage VDD, the first and second input signals IS1 and IS2, the first set of control signals CS1-CS4, and the first set of tuning signals TS1-TS2, the first differential circuit 102a may generate differential outputs, e.g., first and second output signals OS1 and OS2. Similarly, the second differential circuit 102b may receive the supply voltage VDD, the first and second output signals OS1 and OS2 as differential input signals, a second set of control signals CS5-CS8, and a second set of tuning signals TS3-TS4, and generate differential outputs, e.g., third and fourth output signals OS3 and OS4. Further, the Nth differential circuit 102n may receive the supply voltage VDD, output signals generated by a preceding differential circuit as differential input signals, an Nth set of control signals CS(4N-3)-CS(4N), and an Nth set of tuning signals TS(2N-1)-TS(2N), and generate differential outputs, e.g., output signals OS(2N-1) and OS(2N).

The control circuit 104 may be coupled to the first through Nth differential circuits 102a-102n and the power supply 106. The control circuit 104 may receive the differential outputs generated by each differential circuit, e.g., the output signals OS1-OS(2N-1). Based on the outputs signals OS1-OS(2N-1), the control circuit 104 may generate the first through Nth sets of control signals CS1-CS(4N) and the first through Nth sets of tuning signals TS1-TS(2N).

The power supply 106 may correspond to a power supply source that may generate the supply voltage VDD. Although FIG. 1 illustrates that all of the circuits are implemented in the circuit 100, in various embodiments, some of the circuitry may be located external to the circuit 100. For example, in some embodiments, the power supply 106 may be external to the circuit 100.

FIG. 2 illustrates a schematic circuit diagram of the first differential circuit 102a of the multistage differential circuit 102 of FIG. 1 in accordance with an embodiment of the present disclosure. The first differential circuit 102a may include a differential circuit 202 and an offset calibration circuit 204.

The differential circuit 202 may receive the first and second input signals IS1 and IS2 and the first and second calibration currents IC1 and IC2 and generate the first and second output signals OS1 and OS2. In some embodiments, the first and second output signals OS1 and OS2 may include an offset due to process variations, temperature fluctuations, and power supply instability in the differential circuit 202. The offset calibration circuit 204 may calibrate the offset between the first and second output signals OS1 and OS2 by providing the first and second calibration currents IC1 and IC2 at the source side of the differential circuit 202 as explained in the ongoing disclosure. The differential circuit 202 may include first and second nodes N1 and N2, first and second transistors T1 and T2, and first and second bias current sources 206a and 206b.

### First and second bias current sources 206a and 206b:

The first bias current source 206a may include a first terminal coupled with the first node N1 and a second terminal coupled to the voltage supply source. The first bias current source 206a may generate a first bias current IB1 at the first terminal of the first bias current source 206a. The first bias current source 206a may provide the first bias current IB1 to the transistor T1 via the first node N1 for biasing the first transistor T1 (e.g., to achieve desired amplification of the first input signal IS1). Similarly, the second bias current source 206b may include a first terminal coupled with the second node N2 and a second terminal coupled to the voltage supply source. The second bias current source 206b may generate a second bias current IB2 at the first terminal of the second bias current source 206b. The second bias current source 206b may provide the second bias current IB2 to the transistor T2 via the second node N2 for biasing the second transistor T2 (e.g., to achieve desired amplification of the second input signal IS2). In one embodiment, the voltage supply source may correspond to ground, a positive voltage signal, or a negative voltage signal.

### First and second transistors T1 and T2:

The first transistor T1 may include a first input control terminal, a first output control terminal coupled to the control circuit 104, and a first current supply terminal coupled to the first node N1. The first transistor T1 may receive the first input signal IS1 at the first input control terminal and the first bias current IB1 at the first current supply terminal via the first node N1, and generate the first output signal OS1 at the first output control terminal. In one embodiment, the first transistor T1 may amplify and invert the first input signal IS1 to generate the first output signal OS1 based on the first bias current IB1. In one example, the first output signal OS1 may correspond to an amplified and inverted version of the first input signal IS1.

Similarly, the second transistor T2 may include a second input control terminal, a second output control terminal coupled to the control circuit 104, and a second current supply terminal coupled to the second node N2. Further, the second transistor T2 may receive the second input signal IS1 at the second input control terminal and the second bias current IB2 at the second current supply terminal via the second node N2, and generate the second output signal OS2 at the second output control terminal. In one embodiment, the second transistor T2 may amplify and invert the second input signal IS2 to generate the second output signal OS2 based on the second bias current IB2. In one example, the second output signal OS2 may correspond to an amplified and inverted version of the second input signal IS2. Thus, the first and second transistors T1 and T2 may amplify a voltage difference between the first and second input signals IS1 and IS2. In an embodiment, the first and second transistors T1 and T2 are n-channel metal-oxide-semiconductor (NMOS) transistors, and the current supply terminals, the input control terminals, and the output control terminals of the first and second transistors T1 and T2 correspond to source, gate, and drain terminals, respectively. However, in other embodiments, the first and second transistors T1 and T2 may be other types of transistors such as bipolar transistors or p-channel metal-oxide-semiconductor (PMOS) transistors.

In an embodiment, each differential circuit of the multistage differential circuit 102 may be implemented using NMOS transistors. However, in other embodiments, each differential circuit of the multistage differential circuit 102 may be implemented using PMOS transistors such that the first and second bias current sources 206a and 206b are coupled between the first and second transistors T1 and T2, and the supply voltage VDD and the resistors R2 and R3 are coupled between the first and second transistors T1 and T2 and ground.

### Control circuit 104:

The control circuit 104 as shown in Figure 1, may receive the first output signal OS1 and the second output signal OS2 from the first and second transistors T1 and T2 of the differential circuit 202. Based on the first output signal OS1 and the second output signal OS2, the control circuit 104 may generate the first set of control signals CS1-CS4 and the first set of tuning signals TS1 and TS2. The first set of control signals CS1-CS4 may include first through fourth control signals CS1-CS4.

### Offset calibration circuit 204:

The offset calibration circuit 204 may be coupled to the differential circuit 202 and the control circuit 104. The offset calibration circuit 204 may receive the first set of control signals CS1-CS4 and the first set of tuning signals TS1 and TS2 from the control circuit 104. Based on the first set of control signals CS1-CS4 and the first set of tuning signals TS1 and TS2, the offset calibration circuit 204 may generate first and second calibration currents IC1 and IC2 for calibration of the offset between the first and second output signals OS1 and OS2.

The offset calibration circuit 204 may include first and second calibration current sources 208a and 208b to generate first and second calibration currents IC1 and IC2, and a plurality of control inputs to receive the first set of control signals CS1-CS4. The offset calibration circuit 204 may further include a plurality of control outputs to provide the first and second calibration currents IC1 and IC2 at the first and second nodes N1 and N2 of the differential circuit 202 based on the first set of control signals CS1-CS4. In one scenario, the offset calibration circuit 204 may provide the first and second calibration currents IC1 and IC2 at the first and second nodes N1 and N2, respectively. In another scenario, the offset calibration circuit 204 may provide the first and second calibration currents IC1 and IC2 at the second and first nodes N2 and N1, respectively. In one embodiment, the offset calibration circuit 204 may include first through fourth switches S1-S4 that may receive the first set of control signals CS1-CS4 to control steering of the first and second calibration currents IC1 and IC2.

### First through fourth switches S1-S4:

The first switch S1 may be coupled to the first calibration current source 208a, the first node N1, and the control circuit 104. The first switch S1 may include a first terminal to receive the first control signal CS1 of the first set of control signals CS1-CS4, a second terminal to receive the first calibration current IC1, and a third terminal to provide the first calibration current IC1 at the first node N1 based on an assertion of the first control signal CS1, to pull up the first output signal OS1. In one embodiment, to pull up the first output signal OS1, the first calibration current IC1 may be added to the first bias current IB1 resulting in pulling up (e.g., increasing) a voltage level of the first output signal OS1.

The second switch S2 may be coupled to the second calibration current source 208b, the second node N2, and the control circuit 104. The second switch S2 may include a first terminal to receive the second control signal CS2 of the first set of control signals CS1-CS4, a second terminal to receive the second calibration current IC2, and a third terminal to provide the second calibration current IC2 at the second node N2 based on an assertion of the second control signal CS2, to pull down the second output signal OS2. In one embodiment, to pull down the second output signal OS2, the second calibration current IC2 may be subtracted from the second bias current IB2 resulting in pulling down (e.g., decreasing) a voltage level of the second output signal OS2.

The third switch S3 may be coupled to the first calibration current source 208a, the second node N2, and the control circuit 104. The third switch S3 may include a first terminal to receive the third control signal CS3 of the first set of control signals CS1-CS4, a second terminal to receive the first calibration current IC1, and a third terminal to provide the first calibration current IC1 at the second node N2 based on an assertion of the third control signal CS3, to pull up the second output signal OS2. Further, the fourth switch S4 may be coupled to the second calibration current source 208b, the first node N1, and the control circuit 104. The fourth switch S4 may include a first terminal to receive the fourth control signal CS4 of the first set of control signals CS1-CS4, a second terminal to receive the second calibration current IC2, and a third terminal to provide the second calibration current IC2 at the first node N1 based on an assertion of the fourth control signal CS4, to pull down the first output signal OS1.

In operation, when a magnitude of the first output signal OS1 is less than a magnitude of the second output signal OS2, the control circuit 104 may assert the first control signal CS1 and the second control signal CS2. When the first control signal CS1 and the second control signal CS2 may be asserted, the first and second switches S1 and S2 may be activated. Thus, the first output signal OS1 and the second output signal OS2 may be calibrated based on the first calibration current IC1 and the second calibration current IC2, respectively. The first calibration current IC1 may pull up the magnitude of the first output signal OS1 and the second calibration current IC2 may pull down the magnitude of the second output signal OS2 to calibrate the offset between the first and second output signals OS1 and OS2 (e.g., to bring magnitudes of the first and second output signals OS1 and OS2 at the same level).

Further, when the magnitude of the first output signal OS1 is greater than the magnitude of the second output signal OS2, the control circuit 104 may assert the third control signal CS3 and the fourth control signal CS4. When the third control signal CS3 and the fourth control signal CS4 may be asserted, the third and fourth switches S3 and S4 are activated. Thus, the first output signal OS1 and the second output signal OS2 may be calibrated based on the second calibration current IC2 and the first calibration current IC1, respectively. The second calibration current IC2 may pull down the magnitude of the first output signal OS1 and the first calibration current IC1 may pull up the magnitude of the second output signal OS2 to calibrate the offset between the first and second output signals OS1 and OS2.

In one embodiment, an amount by which magnitudes of the first and second output signals OS1 and OS2 may be pulled up or pulled down may be based on magnitudes of the first and second calibration currents IC1 and IC2. The control circuit 104 may provide the first tuning signal TS1 and the second tuning signal TS2 of the first set of tuning signals TS1-TS2 to the first calibration current source 208a and the second calibration current source 208b, respectively. The first and second tuning signals TS1 and TS2 may control magnitudes of the first and second calibration currents IC1 and IC2, respectively. In one embodiment, the first and second calibration currents IC1 and IC2 may be at first and second magnitudes, respectively. The control circuit 104 may monitor the first and second output signals OS1 and OS2 to determine whether the offset between the first and second output signals OS and OS2 is calibrated or uncalibrated at the first and second magnitudes of the first and second calibration currents IC1 and IC2. If the offset between the first and second output signals OS and OS2 may remain uncalibrated at the first and second magnitudes of the first and second calibration currents IC1 and IC2, the control circuit 104 may adjust the first and second tuning signals TS1 and TS2 to increase the magnitudes of the first and second calibration currents IC1 and IC2 for calibration of the offset between the first and second output signals OS and OS2. In one example, the control circuit 104 may adjust the first tuning signal TS1 and the second tuning signal TS2 by a first value (e.g., a predetermined value). In one embodiment, the first value may be predetermined by the control circuit 104. Further, the first tuning signal TS1 and the second tuning signal TS2 may be adjusted by the first value to increase magnitudes of the first calibration current IC1 and the second calibration current IC2, respectively, until the offset between the first output signal OS1 and the second output signal OS2 is calibrated. In one embodiment, the control circuit 104 may determine the first value. Further stated, the first and second tuning signals TS1 and TS2 may be adjusted by the first value iteratively to calibrate the offset between the first and second output signals OS1 and OS2. In one embodiment, the first and second tuning signals TS1 and TS2 are adjusted simultaneously to calibrate the offset between the first and second output signals OS1 and OS2.

### First through third resistors R1-R3:

The differential circuit 202 may further include first through third resistors R1-R3. The first resistor R1 may be coupled between the first and second nodes N1 and N2. The first resistor R1 may include a first terminal coupled to the first node N1 and the first terminal of the first bias current source 206a and a second terminal coupled to the second node N2 and the first terminal of the second bias current source 206b. In one embodiment, the first resistor R1 may be a degeneration resistor implemented to control overdrive of the first and second input signals IS1 and IS2. The second resistor R2 may include a first terminal coupled to the first output control terminal and a second terminal coupled to the voltage supply source. In one embodiment, the second terminal of the second resistor R2 is coupled to the power supply 106 to receive the supply voltage VDD. Similarly, the third resistor R3 may include a first terminal coupled to the second output control terminal and a second terminal coupled to the voltage supply source. In one embodiment, the second terminal of the third resistor R3 is coupled to the power supply 106 to receive the supply voltage VDD. In one embodiment, the second and third resistors R2 and R3 may correspond to load resistors that may regulate a flow of the aforementioned currents in the differential circuit 202.

It will be apparent to a person skilled in the art that the remaining differential circuits 102b-102n may be structurally and functionally similar to the first differential circuit 102a of FIG. 2 and may calibrate an offset between the differential outputs generated by the respective circuit in a similar manner as described in FIG. 2. Thus, each of the first through Nth differential circuits 102b-102n may calibrate the offset resulting in calibration of the overall offset of the multistage circuit.

FIG. 3 illustrates a schematic circuit diagram of the first differential circuit 102a of the multistage differential circuit 102 of FIG. 1 in accordance with another embodiment of the present disclosure. The first differential circuit 102a may include the differential circuit 202, the offset calibration circuit 204, and a correction circuit 302.

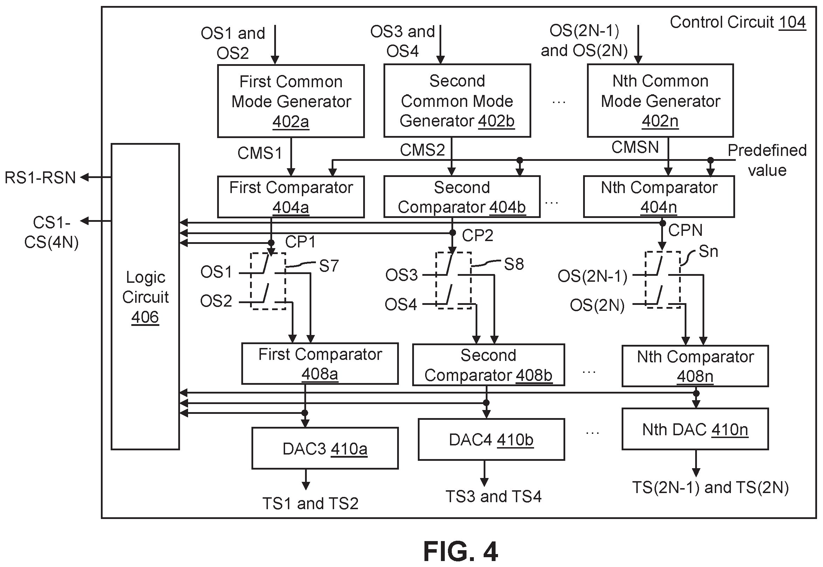

The differential circuit 202 may receive the first and second input signals IS1 and IS2, the first and second calibration currents IC1 and IC2, and first and second correction signals CO1 and CO2, and generate the first and second output signals OS1 and OS2. In some embodiments, the first and second output signals OS1 and OS2 may have a common mode voltage associated with a first common mode signal CMS1 (shown later in FIG. 4) less than a predefined value. The correction circuit 302 may correct the common mode voltage by providing the first and second correcting signals CO1 and CO2 to the differential circuit 202 as explained in the ongoing disclosure. Further, the first and second output signals OS1 and OS2 may include an offset due to process variations, temperature fluctuations, and power supply instability in the differential circuit 202. The offset calibration circuit 204 may calibrate the offset between the first and second output signals OS1 and OS2 by providing the first and second calibration currents IC1 and IC2 at the source side of the differential circuit 202 as explained in the ongoing disclosure. The differential circuit 202 may include the first and second nodes N1 and N2, the first and second transistors T1 and T2, the first and second bias current sources 206a and 206b, the first through third resistors R1-R3, and fifth and sixth switches S5 and S6.

### First and second bias current sources 206a and 206b and First and second transistors T1 and T2:

The first bias current source 206a may generate the first bias current IB1 at the first terminal of the first bias current source 206a and the second bias current source 206b may generate the second bias current IB2 at the first terminal of the second bias current source 206b. The first transistor T1 may receive the first input signal IS1 at the first input control terminal and the first bias current IB1 at the first current supply terminal via the first node N1, and generate the first output signal OS1 at the first output control terminal. Similarly, the second transistor T2 may receive the second input signal IS2 at the second input control terminal and the second bias current IB2 at the second current supply terminal via the second node N2, and generate the second output signal OS2 at the second output control terminal. It will be apparent to a person skilled in the art that the first and second transistors T1 and T2 and the first and second bias current sources 206a and 206b function in a similar manner as described in FIG. 2.

### Control circuit 104:

The control circuit 104 may receive the first output signal OS1 and the second output signal OS2 from the first and second transistors T1 and T2 of the differential circuit 202 and generate the first set of control signals CS1-CS4, the first set of tuning signals TS1 and TS2, and first set of regulating signals RS1 and RS2 based on the first output signal OS1 and the second output signal OS2. In one embodiment, the common mode voltage of the first and second output signals OS1 and OS2 may be less than a predefined value (e.g., a desired value for operation of the differential circuit 202) and thus may require correction. The common mode voltage may correspond to an average of the magnitudes of the first output signal OS1 and the second output signal OS2. When the common mode voltage may be less than the predefined value, the control circuit 104 may correct the common mode voltage. After correction of the common mode voltage, the first calibration current IC1 and the second calibration current IC2 may be steered to calibrate the offset between the first and second output signals OS1 and OS2.

### Fifth and sixth switches S5 and S6:

The fifth switch S5 may include a first terminal coupled to the second resistor R2, a second terminal coupled to the power supply 106 to receive the supply voltage VDD, and a control terminal coupled to the correction circuit 302. The fifth switch S5 may receive the first correction signal CO1 at the control terminal to correct the magnitude of the first output signal OS1. Similarly, the sixth switch S6 may include a first terminal coupled to the third resistor R3, a second terminal coupled to the power supply 106 to receive the supply voltage VDD, and a control terminal coupled to the correction circuit 302. The sixth switch S6 may receive the second correction signal CO2 at the control terminal to correct the magnitude of the second output signal OS2.

### Correction circuit 302:

The correction circuit 302 may be coupled to the differential circuit 202 and the control circuit 104. The correction circuit 302 may receive a first regulating signal RS1 and generate the first correction signal CO1 and the second correction signal CO2 based on the first regulating signal RS1. In one embodiment, the correction circuit 302 may provide the first correction signal CO1 and the second correction signal CO2 at the control terminals of the fifth and sixth switches S5 and S6 of the differential circuit 202 to correct magnitudes of the first output signal OS1 and the second output signal OS2, respectively. The magnitudes of the first output signal OS1 and the second output signal OS2 may be corrected by pulling up the first output signal OS1 and the second output signal OS2 based on the first correction signal CO1 and the second correction signal CO2. In one example, the first output signal OS1 and the second output signal OS2 correspond to a first output voltage and a second output voltage which may be pulled up to desired magnitudes of the first output signal OS1 and the second output signal OS2. The magnitudes of the first output signal OS1 and the second output signal OS2 may be corrected to obtain the common mode voltage greater than or equal to the predefined value. In one example, the predefined value may be 65% of VDD such that a residual common mode signal may be greater than 65% of an operating supply voltage (e.g., VDD) thereby having the input differential pair (e.g., the first and second input signals IS1 and IS2) in saturation regions of the first and second transistors (T1 and T2). In one embodiment, the correction circuit 302 may include a first digital to analog converter (DAC) 304 and a second DAC 306.

### First and second DACs 304 and 306:

The first DAC 304 may be coupled to the fifth switch S5 of the differential circuit 202 and the control circuit 104. The first DAC 304 may receive the first regulating signal RS1 and generate the first correction signal CO1 based on the first regulating signal RS1. Further, the first DAC 304 may provide the first correction signal CO1 to the fifth switch S5 to activate the fifth switch S5 and correct the first output signal OS1 by pulling up the first output signal OS1.

Similarly, the second DAC 306 may be coupled to the sixth switch S6 of the differential circuit 202 and the control circuit 104. The second DAC 306 may receive the first regulating signal RS1 and generate the second correction signal CO2 based on the first regulating signal RS1. Further, the second DAC 306 may provide the second correction signal CO2 to the sixth switch S6 to activate the sixth switch S6 and correct the second output signal OS2 by pulling up the second output signal OS2. When the first and second output signals OS1 and OS2 may be corrected by pulling up the magnitudes of the first and second output signals OS1 and OS2, the common mode voltage may be corrected to be equal to or greater than the predefined value.

In operation, an amount by which magnitudes of the first and second output signals OS1 and OS2 may be pulled up may be based on magnitudes of voltage of the first and second correction signals CO1 and CO2. The control circuit 104 may provide the first regulating signal RS1 to the first and second DACs 304 and 306. The first regulating signal RS1 may control magnitudes of the first and second correction signals CO1 and CO2. The control circuit 104 may monitor the first and second output signals OS1 and OS2 and the common mode voltage to determine whether the common mode voltage is equal to or less than the predefined value at current magnitudes of the first and second correction signals CO1 and CO2. If the common mode voltage is less than the predefined value at the current magnitudes of the first and second correction signals CO1 and CO2, the control circuit 104 may adjust a magnitude of the first regulating signal RS1 by a second value. In one embodiment, the first regulating signal may be a multi-bit digital signal. The second value may be a predetermined value. Further, the first regulating signal RS1 may be adjusted to increase magnitudes of the first correction signal CO1 and the second correction signal CO2, until the common mode voltage is equal to or greater than the predefined value. In one embodiment, the control circuit 104 may determine the second value. The first regulating signal RS1 may be thus adjusted by the second value iteratively to pull up the first and second output signals OS1 and OS2 and correct the common mode voltage.

In one embodiment, the switches S5 and S6 may be implemented by way of NMOS or PMOS transistors such that the first and second correcting signals CO1 and CO2 may control resistance values of the NMOS or PMOS transistors corresponding to the switches S5 and S6 to correct the common mode voltage, respectively.

Upon correction of the common mode voltage, e.g., when the common mode voltage is equal to or greater than the predefined value, the offset calibration circuit 204 may be activated to perform offset calibration for the differential circuit 202. It will be apparent to a person skilled in the art that the offset calibration circuit 204 may be implemented to calibrate the offset between the first and second output signals OS1 and OS2 in a similar manner as described in FIG. 2.

The second resistor R2 may be coupled between the first output control terminal and the fifth switch S5. Similarly, the third resistor R3 may be coupled between the second output control terminal and the sixth switch S6. In one embodiment, the second and third resistors R2 and R3 may correspond to load resistors implemented to regulate current flow in the differential circuit 202.

It will be apparent to a person skilled in the art that the remaining differential circuits 102b-102n may be structurally and functionally similar to the first differential circuit 102a of FIG. 3 and may correct the common mode voltages of the respective differential outputs and calibrate an offset between the differential outputs generated by the respective circuit in a similar manner as described in FIGS. 2 and 3. Thus, each of the first through Nth differential circuits 102b-102n may correct the respective common mode voltages and calibrate the offset resulting in calibration of the overall offset of the multistage differential circuit.

FIG. 4 illustrates a schematic circuit diagram of the control circuit 104 of the circuit 100 of FIG. 1 in accordance with an embodiment of the present disclosure. The control circuit 104 may include a plurality of common mode generators 402a-402n, a first plurality of comparators 404a-404n, a logic circuit 406, a plurality of switches S7-Sn, a second plurality of comparators 408a-408n, and a plurality of DACs 410a-410n.

### Plurality of common mode generators 402a-402n:

The plurality of common mode generators 402a-402n may include first through Nth generators 402a-402n. The first common mode generator 402a may be coupled to the differential circuit 202 of the first differential circuit 102a to receive the first and second output signals OS1 and OS2 and generate the first common mode signal CMS1. It will be understood by a person skilled in the art that the second through nth common mode generators 402b-402n may be coupled to the respective differential circuit to receive respective differential outputs and generate second through nth common mode signals CMS2-CMSN in a manner similar to the generation of the first common mode signal CMS1.

### First plurality of comparators 404a-404n:

The first plurality of comparators 404a-404n may include first through Nth comparators 404a-404n. The first comparator 404a may be coupled to the first common mode generator 402a and the logic circuit 406. The first comparator 404a may compare the first common mode signal CMS1 with the predefined value to generate a first comparison signal CP1. In one embodiment, comparison of the first common mode signal CMS1 with the predefined value may refer to comparison of a voltage level of the first common mode signal CMS1 with the predefined value. The first regulating signal RS1 may be generated based on the first comparison signal CP1. It will be understood by a person skilled in the art that the second through nth comparators 404b-404n may compare the second through nth common mode signals CMS2-CMSN with the predefined value to generate second through nth comparison signals CP2-CPN in a manner similar to the comparison of the first common mode signal CMS1 with the predefined value.

### Logic circuit 406:

The logic circuit 406 may receive the first comparison signal CP1 and the predefined value and increase the magnitude of the first regulating signal RS1 until the common mode voltage associated with the first common mode signal CMS1 is greater than or equal to the predefined value. It will be understood by a person skilled in the art that the second through nth comparators 404b-404n may compare the respective common mode signals to the predefined value and provide the second through Nth comparison signals CP2-CPN to the logic circuit 406 for generation of second through Nth regulating signals RS2-RSN in a manner similar to the generation of the first regulating signal RS1. The logic circuit 406 may provide the first through Nth regulating signals RS1-RSN to the respective differential circuits of the first through Nth differential circuits 102a-102n.

### Plurality of switches S7-Sn:

The plurality of switches S7-Sn may be coupled to the first through Nth differential circuits 102a-102n, the first plurality of comparators 404a-404n, and the second plurality of comparators 408a-408n. Each of the plurality of switches S7-Sn may receive the respective comparison signal of the first through Nth comparison signals CP1-CPN and respective differential outputs and may provide the differential outputs to the respective comparator of the second plurality of comparators 408a-408n when the respective comparison signal indicates that the respective common mode signal is greater than or equal to the predefined value. For example, the seventh switch S7 of the plurality of switches S7-Sn may receive the first and second output signals OS1 and OS2 and the first comparison signal CP1. When the first comparison signal CP1 indicates that the first common mode signal CMS1 is greater than or equal to the predefined value, the seventh switch S7 may provide the first and second output signals OS1 and OS2 to the first comparator 408a.

### Second plurality of comparators 408a-408n:

The second plurality of comparators 408a-408n may include first through Nth comparators 404a-404n. The first comparator 408n of the second plurality of comparators 408a-408n may be coupled to the differential circuit 202 via the seventh switch S7. The first comparator 408n of the second plurality of comparators 408a-408n may receive the first output signal OS1 and the second output signal OS2 and compare the first output signal OS1 and the second output signal OS2. The output of the comparison of the first output signal OS1 and the second output signal OS2 may be provided to the logic circuit 406. The logic circuit 406 may generate the first set of control signals CS1-CS4 based on the received output from the first comparator 408a. In one embodiment, when the first output signal OS1 is less than the second output signal OS2, the first and second control signals CS1 and CS2 may be asserted and the third and fourth control signals CS3 and CS4 may be de-asserted to calibrate the offset between the first and second output signals OS1 and OS2. Further, when the first output signal OS1 is greater than the second output signal OS2, the first and second control signals CS1 and CS2 may be de-asserted and the third and fourth control signals CS3 and CS4 may be asserted to calibrate the offset between the first and second output signals OS1 and OS2.

### Plurality of DACs 410a-410n:

The plurality of DACs 410a-410n may include third through Nth DACs 410a-410n. The third DAC 410a may be coupled to the first comparator 408n of the second plurality of comparators 408a-408n and the offset calibration circuit 204. The third DAC 410a may generate the first tuning signal TS1 and the second tuning signal TS2 based on the first output signal OS1 and the second output signal OS2 to control the generation of the first calibration current IC1 and the second calibration current IC2. It will be understood by a person skilled in the art that the remaining DACs of the plurality of DACs 410a-410n may generate the respective tuning signals TS3-TS(2N) in a manner similar to the generation of the first and second tuning signals TS1 and TS2.

The logic circuit 406 may control a sweep operation of each of the plurality of DACs 410a-410n based on the respective differential output signals. For example, the logic circuit 406 may control a sweep operation of the third DAC 410a based on the first output signal OS1 and the second output signal OS2 to increase the magnitudes of the first and second tuning signals TS1 and TS2, iteratively.

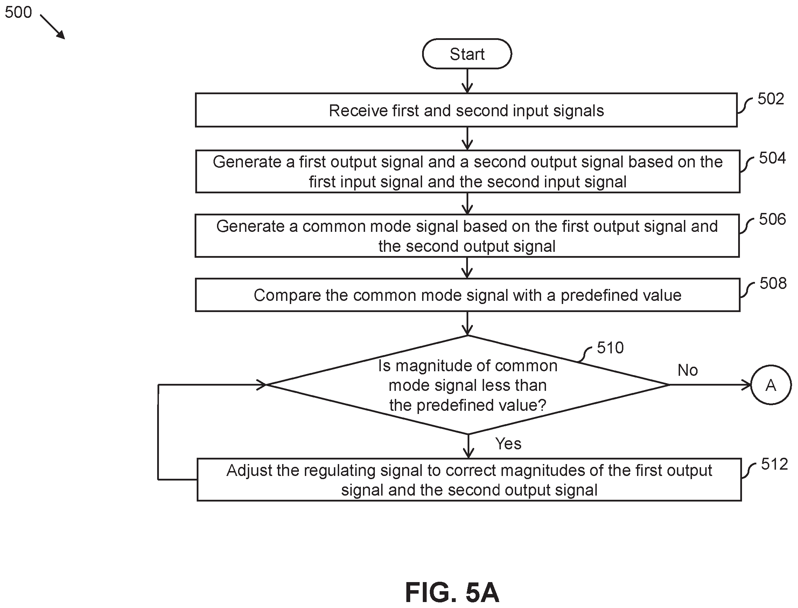

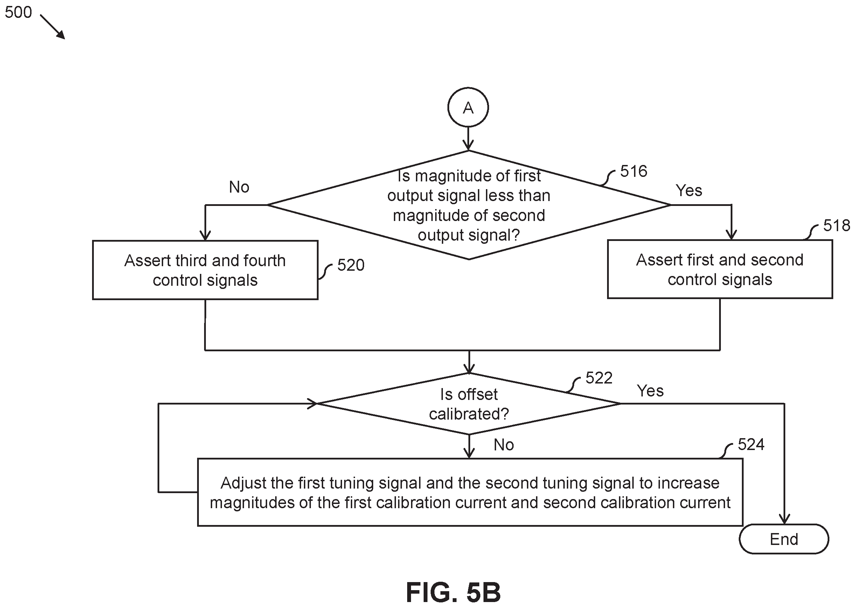

FIGS. 5A and 5B, collectively, represent a flowchart 500 illustrating a method for offset calibration performed by the circuit 100 of FIG. 1 in accordance with an embodiment of the present disclosure. The method may be implemented by each differential circuit of the first through Nth differential circuits 102a-102n to calibrate offset in the respective differential output signals. In the current embodiment, the method is implemented by the first differential circuit 102a to calibrate the offset between the first and second output signals OS1 and OS2.

At 502, the differential circuit 202 may receive the first and second input signals IS1 and IS2. At 504, the differential circuit 202 may generate the first output signal OS1 and the second output signal OS2 based on the first input signal IS1 and the second input signal IS2.

At 506, the control circuit 104 may generate the first common mode signal CMS1 based on the first output signal OS1 and the second output signal OS2. At 508, the control circuit 104 may compare the first common mode signal CMS1 with the predefined value.

At 510, the control circuit 104 may determine whether the magnitude of first common mode signal CMS1 is greater than the predefined value. If at 510, the control circuit 104 determines that the magnitude of first common mode signal CMS1 is less than the predefined value, 512 is executed. At 512, the control circuit 104 may adjust the first regulating signal RS1 to correct magnitudes of the first output signal OS1 and the second output signal OS2. After 512, 510 is executed again. Thus, 510 is executed until the first common mode signal CMS1 is greater than or equal to the predefined value. If at 510, the control circuit 104 determines that the magnitude of the first common mode signal CMS1 is greater than or equal to the predefined value, the magnitude of the first regulating signal RS1 may be fixed by the control circuit 104, and 516 may be executed.

At 516, the control circuit 104 may compare the first output signal OS1 and the second output signal OS2 and determine whether the magnitude of voltage of the first output signal OS1 is less than a magnitude of voltage of the second output signal OS2. If at 516, the control circuit 104 determines that the magnitude of the first output signal OS1 is less than a magnitude of the second output signal OS2, 518 is executed. At 518, the control circuit 104 may assert the first and second control signals CS1 and CS2 to provide the first calibration current IC1 at the first node N1 to pull up the first output signal OS1, and provide the second calibration current IC2 at the second node N2 to pull down the second output signal OS2.

If at 516, the control circuit 104 determines that the magnitude of the first output signal OS1 is greater than the magnitude of the second output signal OS2, 520 is executed. At 520, the control circuit 104 may assert the third and fourth control signals CS3 and CS4 to provide the first calibration current IC1 at the second node N2 to pull up the second output signal OS2, and provide the second calibration current IC2 at the first node N1 to pull down the first output signal OS1. After 518 and 520, 522 may be executed.

At 522, the control circuit 104 may determine whether the offset between the first and second output signals OS1 and OS2 is calibrated. If at 522, the control circuit 104 determines that the offset between the first and second output signals OS1 and OS2 is not calibrated, 524 is executed. At 524, the control circuit 104 may adjust the first tuning signal TS1 and the second tuning signal TS2 to increase magnitudes of the first calibration current IC1 and the second calibration current IC2 to calibrate the offset. If at 522, the control circuit 104 determines that the offset between the first and second output signals OS1 and OS2 is calibrated, the magnitudes of the first and second tuning signals TS1 and TS2 may be fixed by the control circuit 104 and the offset between the first and second output signals OS1 and OS2 may be thus calibrated.

Each of the first through Nth differential circuits 102a-102n may implement the method for calibration of respective offsets of the respective differential output signals resulting into the calibration of the overall offset of the multistage differential circuit.

Thus, by selectively steering the calibration currents, such as the calibration currents IC1 and IC2, based on the set of control signals, such as the first through fourth control signals CS1-CS4, the offset calibration circuit 204 may provide the calibration currents (e.g., first and second calibration currents IC1 and IC2) at the current supply terminals of the differential circuit 202 instead of the output control terminals to overcome the challenges of the conventional techniques. As a result, a set of electrical parameters of the differential circuit 202 may be unaffected by the offset calibration circuit 204. The set of electrical parameters may include at least one of a 3dB bandwidth, 1 dB compression (linearity) when supply is high or low, and Continuous-Time Linear Equalizer (CTLE) boost at Nyquist frequency at the final output of the multistage differential circuit 102. The set of electrical parameters may further include DC gain variation post offset calibration at each differential stage of the multistage differential circuit 102. The disclosed circuit 100 thus facilitates real-time offset calibration, enhancing the accuracy and reliability of differential signal processing under varying operating conditions.

Further, as the offset calibration circuit 204 is coupled at the source side of the differential circuit 202, e.g., coupled at the source terminals of the first and second transistors T1 and T2, and the offset calibration circuit 204 is simple and includes less components than the conventional offset calibration circuits, additional parasitic capacitance is not introduced at the differential outputs of the differential circuit 202. As a result, the bandwidth, such as the 3dB bandwidth, and the set of electrical parameters of the output signal, such as the CTLE boost and DC gain variation, remain unaffected.

In an embodiment of the present disclosure a circuit is disclosed. The circuit may include a differential circuit and a calibration circuit coupled to the differential circuit. The differential circuit may include first and second nodes, first and second input control terminals, and first and second output control terminals. The first and second input control terminals may receive first and second input signals, respectively. The first and second output control terminals may generate first and second output signals at the first and second output control terminals based on the first and second input signals. The calibration circuit may include first and second calibration current sources, a first plurality of control inputs, and a first plurality of control outputs. The first and second calibration current sources may generate first and second calibration currents, respectively. The plurality of control inputs may receive a set of control signals to control steering of the first and second calibration currents. The plurality of control outputs may provide one of (i) the first and second calibration currents at the first and second nodes, respectively, and (ii) the second and first calibration currents at the first and second nodes, respectively, that calibrate an offset between the first and second output signals.

In some embodiments, the differential circuit may further include first and second transistors. The first transistor may include the first input control terminal, a first current supply terminal coupled to the first node, and the first output control terminal. The second transistor may include the second input control terminal, a first current supply terminal coupled to the second node, and the second output control terminal.

In some embodiments, the differential circuit may further include first and second bias current sources. The first bias current source may include a first terminal coupled with the first node and a second terminal coupled to a voltage supply source. The first bias current source may generate the first bias current at the first terminal of the first bias current source. The second bias current source may include a first terminal coupled with the second node and a second terminal coupled to the voltage supply source. The second bias current source may generate the second bias current at the first terminal of the second bias current source.

In some embodiments, the differential circuit may further include first through third resistors. The first resistor may be coupled between the first node and the second node. The second resistor may be coupled between the first output control terminal and the voltage supply source. The third resistor may be coupled between the second output control terminal and the voltage supply source.

In some embodiments, the calibration circuit may further include first and second switches. The first switch may be coupled to the first calibration current source and the first node. The first switch may include a first terminal to receive a first control signal of the set of control signals and a second terminal to provide the first calibration current at the first node based on the first control signal to pull up the first output signal. The second switch may be coupled to the second calibration current source and the second node. The second switch may include a first terminal to receive a second control signal of the set of control signals and a second terminal to provide the second calibration current at the second node based on the second control signal to pull down the second output signal.

In some embodiments, the offset calibration circuit may further include third and fourth switches. The third switch may be coupled to the first calibration current source and the second node. The third switch may include a first terminal to receive a third control signal of the set of control signals and a second terminal to provide the first calibration current at the second node based on the third control signal to pull up the second output signal. The fourth switch may be coupled to the second calibration current source and the first node. The fourth switch may include a first terminal to receive a fourth control signal of the set of control signals and a second terminal to provide the second calibration current at the first node based on the fourth control signal to pull down the first output signal.

In some embodiments, the circuit may further include a control circuit. The control circuit may be coupled to the differential circuit and the offset calibration circuit. The control circuit may receive the first output signal and the second output signal from the differential circuit and generate the set of control signals based on the first output signal and the second output signal.

In some embodiments, the set of control signals include the first through fourth control signals. The control circuit may assert (i) the first control signal and the second control signal when a magnitude of the first output signal is less than a magnitude of the second output signal and (ii) the third control signal and the fourth control signal when a magnitude of the first output signal is greater than a magnitude of the second output signal. When the first control signal and the second control signal are asserted, the first output signal and the second output signal are calibrated based on the first calibration current and the second calibration current, respectively, and when the third control signal and the fourth control signal are asserted, the first output signal and the second output signal are calibrated based on the second calibration current and the first calibration current, respectively.

In some embodiments, the circuit comprises a control circuit coupled to the differential circuit and the calibration circuit. The control circuit may generate a first tuning signal and a second tuning signal based on the first output signal and the second output signal, provide the first tuning signal and the second tuning signal to the first calibration current source and the second calibration current source, respectively, and adjust the first tuning signal and the second tuning signal by a predetermined value to increase magnitudes of the first calibration current and the second calibration current, respectively, to calibrate the offset between the first output signal and the second output signal.

In some embodiments, the circuit may further include a correction circuit coupled to the differential circuit. The correction circuit may receive a regulating signal, generate a first correction signal and a second correction signal based on the regulating signal, and provide the first correction signal and the second correction signal to the differential circuit to correct magnitudes of the first output signal and the second output signal, respectively. The magnitudes of the first output signal and the second output signal may be corrected to obtain a common mode signal greater than or equal to a predefined value.

In some embodiments, the common mode signal corresponds to an average of the magnitudes of the first output signal and the second output signal. The first calibration current and the second calibration current are steered when the common mode signal is greater than or equal to the predefined value.

In some embodiments, the correction circuit may include first and second digital to analog converters (DACs) coupled to the differential circuit. The first DAC may receive the regulating signal, generate the first correction signal based on the regulating signal, and provide the first correction signal to the differential circuit. The second DAC coupled to the differential circuit, and that may receive the regulating signal, generate the second correction signal based on the regulating signal, and provide the second correction signal to the differential circuit.

In some embodiments, the differential circuit may include first and second transistors, first and second resistors, and fifth and sixth switches. The first transistor may include the first input control terminal, a first current supply terminal coupled to the first node, and the first output control terminal. The second transistor may include the second input control terminal, a second current supply terminal coupled to the second node, and the second output control terminal. The first resistor may be coupled to the first output control terminal. The second resistor may be coupled to the second output control terminal. The fifth switch mat include a first terminal coupled to the first resistor, a second terminal coupled to a power supply, and a control terminal coupled to the correction circuit. The fifth switch may receive the first correction signal at the control terminal to correct the magnitude of the first output signal. The sixth switch may include a first terminal coupled to the second resistor, a second terminal coupled to the power supply, and a control terminal coupled to the correction circuit. The sixth switch may receive the second correction signal at the control terminal to correct the magnitude of the second output signal.

In some embodiments, the differential circuit may further include first and second bias current sources and a third resistor. The first bias current source may include a first terminal coupled with the first node and a second terminal coupled to a voltage supply source. The first bias current source may generate the first bias current at the first terminal of the first bias current source. The second bias current source may include a first terminal coupled with the second node and a second terminal coupled to the voltage supply source. The second bias current source may generate the second bias current at the first terminal of the second bias current source. The third resistor may be coupled between the first node and the second node.

In some embodiments, the circuit may further include a control circuit. The control circuit may generate the regulating signal based on the common mode signal and adjust the regulating signal by a predetermined value until the common mode signal is greater than or equal to the predefined value.

In some embodiments, the control circuit may include a first common mode generator coupled to the differential circuit and a first comparator coupled to the first common mode generator. The first common mode generator may receive the first and second output signals and generate the common mode signal based on the first and second output signals. The first comparator may compare the common mode signal with the predefined value. The regulating signal is generated based on the comparison of the common mode signal with the predefined value.

In some embodiments, the control circuit may further include a second comparator coupled to the differential circuit, a third DAC coupled to the calibration circuit, and a logic circuit coupled to the second comparator and the third DAC. The second comparator may receive the first output signal and the second output signal and compare the first output signal and the second output signal. The set of control signals is generated based on the comparison of the first output signal and the second output signal. The third DAC may generate a first tuning signal and a second tuning signal based on the first output signal and the second output signal to control the generation of the first calibration current and the second calibration current. The logic circuit may generate the set of control signals and control a sweep operation of the third DAC based on the first output signal and the second output signal.

In another embodiment of the present disclosure, a circuit comprising a plurality of differential circuits is disclosed.

In some embodiments, the plurality of differential circuits may be coupled sequentially.

In yet another embodiment of the present disclosure, a circuit is disclosed. The circuit may include a differential circuit and an offset calibration circuit coupled to the differential circuit. The differential circuit may include first and second nodes, first and second input control terminals, and first and second output control terminals. The first and second input control terminals may receive first and second input signals, respectively. The first and second output control terminals may generate first and second output signals at the first and second output control terminals based on the first and second input signals. The offset calibration circuit may include first and second calibration current sources, a plurality of control inputs, and a plurality of control outputs. The first and second calibration current sources may generate first and second calibration currents. The plurality of control inputs may receive a set of control signals. The plurality of control outputs may provide, based on the set of control signals, one of (i) the first and second calibration currents at the first and second nodes, respectively, and (ii) the second and first calibration currents at the first and second nodes, respectively.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the spirit and scope of the present disclosure, as described in the claims. Further, unless stated otherwise, terms such as "first" and "second" are used to arbitrarily distinguish between the elements such terms describe. Thus, these terms are not necessarily intended to indicate temporal or other prioritization of such elements. The term "coupled" may refer to at least one of direct or indirect coupling that may not necessarily be by way of mechanical or any physical means. Further, a system or method that "comprises", "has", or "includes" one or more elements possesses those one or more elements but is not limited to possessing only those one or more elements.

## Claims

1. A circuit, comprising:
a differential circuit including:
first and second nodes;
first and second input control terminals to receive first and second input signals, respectively; and
first and second output control terminals to generate first and second output signals at the first and second output control terminals based on the first and second input signals; and
a calibration circuit coupled to the differential circuit, wherein the calibration circuit comprises:
first and second calibration current sources to generate first and second calibration currents, respectively;
a plurality of control inputs to receive a set of control signals to control steering of the first and second calibration currents; and
a plurality of control outputs to provide one of (i) the first and second calibration currents at the first and second nodes, respectively, and (ii) the second and first calibration currents at the first and second nodes, respectively, that calibrate an offset between the first and second output signals.

2. The circuit of claim 1, wherein the differential circuit comprises:
a first transistor including the first input control terminal, a first current supply terminal coupled to the first node, and the first output control terminal; and
a second transistor including the second input control terminal, a first current supply terminal coupled to the second node, and the second output control terminal.

3. The circuit of claim 2, wherein the differential circuit further comprises:
a first bias current source including a first terminal coupled with the first node and a second terminal coupled to a voltage supply source, wherein the first bias current source generates the first bias current at the first terminal of the first bias current source; and
a second bias current source including a first terminal coupled with the second node and a second terminal coupled to the voltage supply source, wherein the second bias current source generates the second bias current at the first terminal of the second bias current source.

4. The circuit of claim 3, wherein the differential circuit further comprises:
a first resistor coupled between the first node and the second node;
a second resistor coupled between the first output control terminal and the voltage supply source; and
a third resistor coupled between the second output control terminal and the voltage supply source.

5. The circuit of any preceding claim, wherein the calibration circuit further comprises:
a first switch coupled to the first calibration current source and the first node, wherein the first switch includes:
a first terminal to receive a first control signal of the set of control signals; and
a second terminal to provide the first calibration current at the first node based on the first control signal to pull up the first output signal; and
a second switch coupled to the second calibration current source and the second node, wherein the second switch includes:
a first terminal to receive a second control signal of the set of control signals; and
a second terminal to provide the second calibration current at the second node based on the second control signal to pull down the second output signal.

6. The circuit of claim 5, wherein the calibration circuit further comprises:
a third switch coupled to the first calibration current source and the second node, wherein the third switch includes:
a first terminal to receive a third control signal of the set of control signals; and
a second terminal to provide the first calibration current at the second node based on the third control signal to pull up the second output signal; and
a fourth switch coupled to the second calibration current source and the first node, wherein the fourth switch includes:
a first terminal to receive a fourth control signal of the set of control signals; and
a second terminal to provide the second calibration current at the first node based on the fourth control signal to pull down the first output signal.

7. The circuit of claim 6, further comprising:
a control circuit coupled to the differential circuit and the calibration circuit, wherein the control circuit:
receives the first output signal and the second output signal from the differential circuit; and
generates the set of control signals based on the first output signal and the second output signal.

8. The circuit of claim 7, wherein the set of control signals include the first through fourth control signals, wherein
the control circuit asserts (i) the first control signal and the second control signal when a magnitude of the first output signal is less than a magnitude of the second output signal and (ii) the third control signal and the fourth control signal when a magnitude of the first output signal is greater than a magnitude of the second output signal, and wherein
when the first control signal and the second control signal are asserted, the first output signal and the second output signal are calibrated based on the first calibration current and the second calibration current, respectively, and when the third control signal and the fourth control signal are asserted, the first output signal and the second output signal are calibrated based on the second calibration current and the first calibration current, respectively.

9. The circuit of any preceding claim, further comprising:
a control circuit coupled to the differential circuit and the calibration circuit, wherein the control circuit:
generates a first tuning signal and a second tuning signal based on the first output signal and the second output signal;
provides the first tuning signal and the second tuning signal to the first calibration current source and the second calibration current source, respectively; and
adjusts the first tuning signal and the second tuning signal to increase magnitudes of the first calibration current and the second calibration current, respectively, to calibrate the offset between the first output signal and the second output signal.

10. The circuit of any preceding claim, further comprising:
a correction circuit coupled to the differential circuit, wherein the correction circuit:
receives a regulating signal;
generates a first correction signal and a second correction signal based on the regulating signal; and
provides the first correction signal and the second correction signal to the differential circuit to correct magnitudes of the first output signal and the second output signal, respectively, wherein the magnitudes of the first output signal and the second output signal are corrected to obtain a common mode signal greater than or equal to a predefined value.

11. The circuit of claim 10, wherein the common mode signal corresponds to an average of the magnitudes of the first output signal and the second output signal, and wherein the first calibration current and the second calibration current are steered when the common mode signal is greater than or equal to the predefined value.

12. The circuit of claim 10 or 11, wherein the correction circuit comprises:
a first digital to analog converter, DAC, coupled to the differential circuit, wherein the first DAC:
receives the regulating signal;
generates the first correction signal based on the regulating signal; and
provides the first correction signal to the differential circuit; and
a second DAC coupled to the differential circuit, wherein the second DAC:
receives the regulating signal;
generates the second correction signal based on the regulating signal; and
provides the second correction signal to the differential circuit.

13. The circuit of any of claims 10 to 12, wherein the differential circuit comprises:
a first transistor including the first input control terminal, a first current supply terminal coupled to the first node, and the first output control terminal;
a second transistor including the second input control terminal, a second current supply terminal coupled to the second node, and the second output control terminal;
a first resistor coupled to the first output control terminal;
a second resistor coupled to the second output control terminal;
a fifth switch including a first terminal coupled to the first resistor, a second terminal coupled to a power supply, and a control terminal coupled to the correction circuit, wherein the fifth switch:
receives the first correction signal at the control terminal to correct the magnitude of the first output signal; and
a sixth switch including a first terminal coupled to the second resistor, a second terminal coupled to the power supply, and a control terminal coupled to the correction circuit, wherein the sixth switch:
receives the second correction signal at the control terminal to correct the magnitude of the second output signal.

14. The circuit of claim 13, wherein the differential circuit further comprises:
a first bias current source including a first terminal coupled with the first node and a second terminal coupled to a voltage supply source, wherein the first bias current source generates the first bias current at the first terminal of the first bias current source;
a second bias current source including a first terminal coupled with the second node and a second terminal coupled to the voltage supply source, wherein the second bias current source generates the second bias current at the first terminal of the second bias current source; and
a third resistor coupled between the first node and the second node.

15. The circuit of any or claims 10 to 14, further comprising:
a control circuit that:
generates the regulating signal based on the common mode signal; and
adjusts the regulating signal by a predetermined value until the common mode signal is greater than or equal to the predefined value.
